**Europäisches Patentamt**

**European Patent Office**

**Office européen des brevets**

(19)

(11) Numéro de publication: **0 114 760**
**B1**

(12) # FASCICULE DE BREVET EUROPEEN

(45) Date de publication du fascicule du brevet:
**30.03.88**

(51) Int. Cl.⁴: **H 01 L 23/04**

(21) Numéro de dépôt: **84400003.4**

(22) Date de dépôt: **03.01.84**

(54) **Boîtier à dissipation thermique élevée, notamment pour microélectronique.**

(30) Priorité: **07.01.83 FR 8300172**

(43) Date de publication de la demande:
**01.08.84 Bulletin 84/31**

(45) Mention de la délivrance du brevet:
**30.03.88 Bulletin 88/13**

(84) Etats contractants désignés:
**DE GB IT**

(56) Documents cités:
**FR - A - 2 121 454**
**FR - A - 2 216 751**
**FR - A - 2 436 497**
**FR - A - 2 436 498**
**US - A - 4 172 261**

(73) Titulaire: **XERAM, Tour Manhattan 6, place de l'Iris La Défense, F-92400 Courbevoie (FR)**

(72) Inventeur: **Lebailly, Michel, THOMSON-CSF SCPI 173, bld Haussmann, F-75379 Paris Cedex 08 (FR)**
Inventeur: **Jacquemin, Maurice, THOMSON-CSF SCPI 173, bld Haussmann, F-75379 Paris Cedex 08 (FR)**

(74) Mandataire: **Séraphin, Léon et al, PECHINEY 28, rue de Bonnel, F-69433 Lyon Cedex 3 (FR)**

## Description

La présente invention a pour objet un boîtier à dissipation thermique élevée comportant un fond en matériau bon conducteur de la chaleur sur lequel est rapporté par brasure un cadre métallique supportant des connexions par l'intermédiaire de traversées isolantes en verre, notamment pour microélectronique. Un tel boîtier est connu de FR-A-2 436 497.

On sait que l'évolution actuelle des circuits intégrés et des circuits hybrides conduit à des dissipations thermiques par unité de surface qui ne cessent de croître.

L'évacuation des calories ainsi produites doit se faire par l'intermédiaire du boîtier sur lequel le ou les circuits sont montés.

Il est alors essentiel que le boîtier assure une résistance thermique optimale pour que celui-ci soit susceptible d'assurer l'évacuation d'un nombre élevé de calories par unité de surface de substrat (à titre d'exemple, des résistances thermiques aussi faibles que 1 °C/W sont souhaitables).

On connaît ainsi des boîtiers hermétiques couramment disponibles et qui sont constitués d'un corps ou cuvette en alliage Fe-Ni-Co sur lequel sont scellées avec un verre borosilicate des traversées également en alliage Fe-Ni-Co. Un substrat est collé ou brasé sur le fond du boîtier qui, du fait qu'il est en alliage Fe-Ni-Co, est un mauvais dissipateur thermique.

La présente invention concerne donc un boîtier à dissipation thermique élevée pouvant être particulièrement utilisé pour les circuits intégrés et/ou hybrides de micro-électronique et qui présente une résistance thermique optimale compatible avec une diminution de la dimension de boîtiers.

L'invention concerne ainsi un boîtier à dissipation thermique élevée, comportant un fond en matériau bon conducteur de la chaleur sur lequel est rapporté par brasure un cadre métallique supportant des connexions par l'intermédiaire de traversées isolantes en verre, caractérisé en ce que ladite brasure est une brasure dure, le matériau du cadre et celui du fond étant choisis en fonction de leur coefficient de dilatation thermique pour que le fond du boîtier ne présente pas, pour l'application considérée, de défaut de planéité après le refroidissement consécutif au passage de la température de brasure à la température ambiante, les traversées isolantes étant en verre sodocalcique et ayant un coefficient de dilatation thermique inférieur ou égal à celui du matériau constituant le cadre métallique, les connexions étant des broches en un alliage comportant au moins du fer et du nickel.

Selon une première variante au moins un des matériaux est magnétique et les coefficients de dilatation thermique des deux matériaux sont voisins depuis l'ambiante jusqu'à la température de Curie du ou des matériaux magnétiques.

Le fond peut être ainsi en molybdène et le cadre en alliage Fe-Ni-Co. La brasure dure peut comporter une masse 72% d'argent et 28% de cuivre. Les connexions peuvent être des broches en Fe-Ni-Co.

Le fond peut être également en oxyde de béryllium et le cadre en alliage Fe-Ni avec une teneur en Ni comprise entre 42 et 54% en poids. La teneur en Ni est de préférence égale à 50%. La brasure dure peut être choisie parmi l'Ag-Cu et l'Ag-Cu-In. Les traversées isolantes sont en verre sodocalcique et les connexions sont des broches qui peuvent être en alliage Fe-Ni- La teneur en Ni des broches est de préférence la même que celle du cadre métallique.

Selon une deuxième variante, le fond est en cuivre et le cadre en acier inox, c'est-à-dire en des matériaux ayant des coefficients de dilatation thermique voisins depuis l'ambiante jusqu'à la température de soudure de la brasure dure, par exemple du Ni-Au. Les traversées isolantes sont en verre sodocalcique et les connexions sont des broches qui peuvent être en alliage Fe-Ni.

L'invention concerne également un boîtier tel que défini ci-dessus et comportant au moins un substrat brasé sur le fond à l'aide d'une brasure dure dont la température de brasage est inférieure à celle de la brasure utilisée pour le brasage du cadre métallique sur le fond, par exemple de l'Au-Sn qui est la brasure dure dont la température de fusion est la plus faible, ou à l'aide d'une brasure tendre à température de fusion élevée, par exemple du Sn-Pb-Ag ou du Pb-Ag.

L'invention sera mieux comprise à la lecture de la description qui va suivre donnée à titre d'exemple non limitatif, en relation avec les dessins annexés qui représentent:

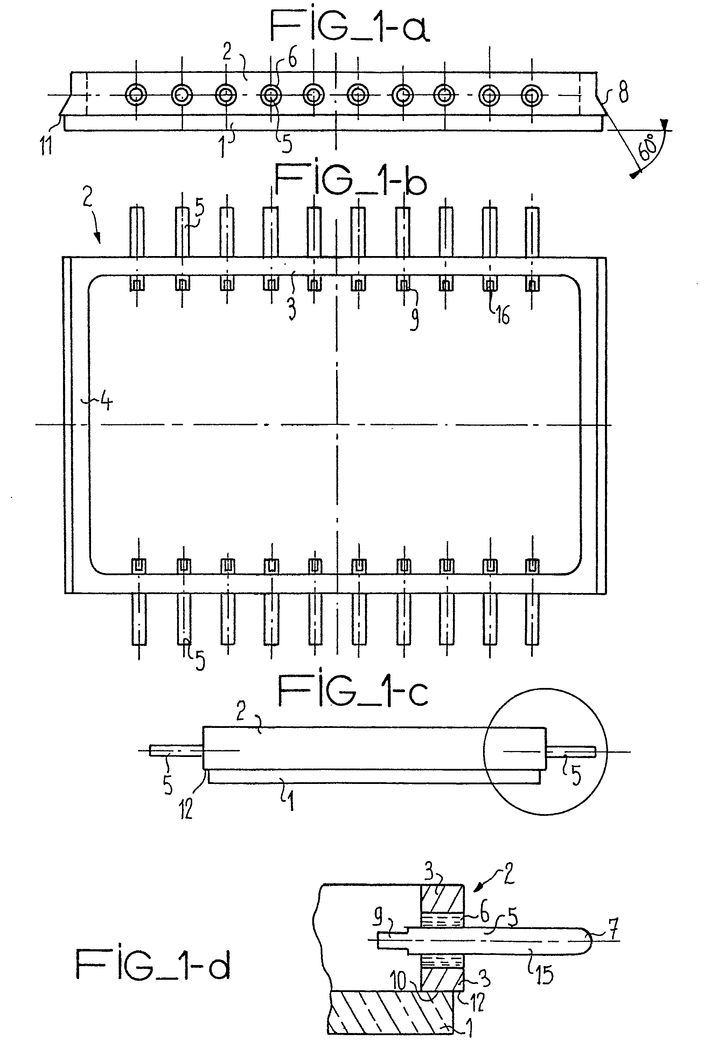

– la figure 1a et 1b, un boîtier selon l'invention respectivement en vue de côté et en vue de dessus,

– la figure 1c, la vue de gauche du boîtier de la figure 1a,

– la figure 1d, un détail de la figure 1c.

Le boîtier selon l'invention comporte un fond 1 en matériau bon conducteur thermique sur lequel est brasé un cadre 2 comportant des côtés longitudinaux 3 sur lesquels sont scellées des connexions 5 par des perles de verre, et des côtés transversaux 4. Les matériaux aptes au scellement n'étant pas très bons conducteurs thermiques, l'utilisation d'un fond rapporté est avantageuse sur le plan thermique. Le cadre 2 (voir figure 1d) est brasé en 10 sur le fond 1 et présente à cet effet des dimensions extérieures plus grandes que celles du fond 1 de manière à produire des décrochements en saillie référencés 12 sur les côtés longitudinaux 3, et 11 sur les côtés transversaux 4. On notera que les côtés transversaux 4 présentent à cet effet deux pans inclinés 8, les côtés latéraux 4 étant, comme représentés, distants l'un de l'autre à leur partie supérieure d'une distance inférieure à la longueur du fond 1.

Les connexions 5 se présentent sous la forme de broches dont chacune est maintenue en position par une traversée isolante 6. On utilise classiquement à cet effet une perle de verre. Chaque broche 5 présente une partie 15 dépassant à l'extérieur du boîtier et qui se termine par une ogive 7, et une partie 9 dépassant à l'intérieur du boîtier et présentant une fente 16 destinée à la soudure d'un fil de connexion du ou des circuits dont doit être muni le boîtier. Après montage d'un ou plusieurs substrats sur le boîtier, un couvercle non représenté est soudé ou brasé sur le cadre 2 de manière à rendre le boîtier hermétique. La brasure peut être réalisée classiquement en intercalant une préforme en alliage fusible.

On rappellera que la température de fonctionnement maximale d'une puce semi-conductrice d'un substrat étant nominalement de l'ordre de 120 à 130°C, il n'existe pas de problème de tenue en température des brasures du boîtier après sa mise en service.

Selon l'invention, le cadre 2 est brasé sur le fond par une brasure dure. Une brasure dure est définie comme une brasure présentant après refroidissement uniquement des déformations élastiques et pratiquement pas ou pas de déformation plastique. Ces brasures sont en général réalisées à des températures relativement élevées à l'exception toutefois de la brasure Au-Sn comprenant 80% d'or et 20% d'étain et qui se soude à partir de 280°C. Une brasure tendre est une brasure en général à base d'étain-plomb (Sn-Pb) dont le module d'Young est faible, et qui peut de ce fait subir des déformations élastiques et des déformations plastiques.

Un tel boîtier est destiné à recevoir un ou plusieurs substrats fixés sur celui-ci par brasage. Or, d'une part la brasure du ou des substrats sur le fond du boîtier doit s'effectuer de manière à éviter la refusion de la brasure entre le fond et le cadre et d'autre part, la demanderesse a constaté que les brasures dures ont une meilleure conductivité thermique que les brasures tendres, et parmi les brasures tendres, les meilleures propriétés thermiques sont le fait de brasures qui présentent une température de fusion élevée.

L'optimisation de la conduction thermique substrat-fond du boîtier, outre le fait que le fond est intrinsèquement très bon conducteur thermique, dépend dès lors de la possibilité de souder le ou les substrats à température relativement élevée. Comme les brasures dures ou tendres favorables sur le plan thermique ont toutes un point de fusion de température relativement élevée, il en résulte que le cadre 2 doit être lui-même soudé par brasure dure sur le fond 1 faute de quoi il y aurait refusion partielle de la brasure au niveau du cadre lors du brasage du substrat sur le fond, et défaut d'étanchéité du boîtier.

Comme on l'a indiqué plus haut, le cadre reçoit des connexions maintenues en place par des perles de verre. Les matériaux compatibles avec le scellement de perles de verre ne sont pas de très bons conducteurs thermiques et le matériau constituant le fond doit être selon l'invention aussi bon conducteur de la chaleur que possible. Or une brasure dure, comme on l'a également indiqué plus haut ne présente pratiquement pas de déformation plastique. Selon l'invention, on choisit le matériau du cadre et le matériau du fond de manière telle que leurs coefficients de dilatation thermique soient voisins au moins sur une partie importante de la gamme de température s'étendant depuis l'ambiante jusqu'à la température de fusion de la brasure dure de telle sorte que le fond ne présente pas de défaut de planéité après refroidissement.

En particulier, les matériaux magnétiques présentent des courbes de dilatation thermique présentant un point d'inflexion à leur température de Curie. La Demanderesse a cependant constaté que même en utilisant des brasures dures à des températures bien supérieures à la température de Curie, le boîtier conservait sa tenue mécanique et son étanchéité dans la mesure où les coefficients de dilatation des deux matériaux étaient voisins dans le domaine de température inférieur à la température de Curie, que l'on utilise un ou deux matériaux présentant un point de Curie. Une explication de ce phénomène est que probablement, une brasure dure à l'état solide est susceptible de subir des déformations plastiques lorsqu'elle est à température élevée, c'est-à-dire qu'elle se comporte dans une gamme de température au voisinage de son point de fusion comme une brasure tendre et absorbe plastiquement les différences de coefficient de dilatation.

Exemple I

On réalise un boîtier pourvu d'un fond en oxyde de beryllium (coefficient de dilatation 90 $10^{-7}$) et d'un cadre en alliage Fe-Ni comportant en poids 50% de Fe et 50% de Ni (coefficient de dilatation égal à environ 102 $10^{-7}$ en dessous du point de Curie). On remarquera que le coefficient de dilatation de l'alliage Fe-Ni en dessous du point de Curie varie de 60 à 105 $10^{-7}$ quand la teneur en Ni varie de 42 à 54% ce qui fait qu'une teneur en Ni autour de 50% peut convenir pour adapter les coefficients de dilatation. Au-delà du point de Curie, et quelque soit la teneur en Ni, la courbe de dilatation des alliages Fe-Ni devient pratiquement parallèle à celle de Fe ou de Ni.

L'assemblage du boîtier a lieu en deux opérations à savoir un premier passage au four où des broches en alliages Fe-Ni, et préférentiellement dans le même alliage que celui constituant le cadre, sont mises en place par fusion de perles de verre en verre sodocalcique, et un second passage au four où le cadre et le fond sont brasés ensemble à 600°C à l'aide d'une brasure Ag-Cu-In comportant en poids 42% d'Ag, 33% de Cu et 25% d'Sn ou vers 800°C à l'aide d'une brasure Ag-Cu comportant en poids 72% d'Ag et 28% de Cu.

Exemple II

On réalise un boîtier pourvu d'un fond en Cu et d'un cadre en acier inox, tous les deux ayant un coefficient de dilatation de 165 $10^{-7}$ environ jusqu'à 600°C et variant peu au-delà de cette température. L'assemblage du boîtier a lieu en deux opérations à savoir un premier passage au four où des broches en Fe-Ni, notamment avec une proportion pondérale de Ni égale à 50%, sont mises en place par fusion de perles de verre, en verre sodocalcique (notamment verre type T fabriqué par Fusite ou type 9013 fabriqué par Corning Glass Works) vers 1000 °C, et un second passage au four où le cadre et le fond sont brasés ensemble vers 720 °C à l'aide d'une brasure Ag-Cu-In comprenant en poids 60% d'Ag, 27% de Cu et 13% d'In ou vers 800 °C à l'aide d'une brasure Ag-Cu comportant en poids 72% d'Ag et 28% de Cu.

Exemple III

Comme dans l'exemple II le fond du boîtier est en Cu et le cadre en acier inox.

Le boîtier est assemblé en un seul passage au four, où des broches en alliage Fe-Ni (par exemple comprenant 50% en poids de Ni) sont mises en place par fusion de perles de verre, en verre sodocalcique (notamment verre type T fabriqué par Fusite ou type 9013 fabriqué par Corning Glass Works) et la brasure du cadre sur le fond est effectuée à l'aide d'une brasure Au-Ni. La température de brasure habituelle (vers 950 °C) de la brasure Au-Ni (qui fond à 900 °C) est en effet compatible avec la température de fusion des verres sodocalcique de telle sorte que ces deux opérations peuvent avoir lieu à la même température (environ 1000 °C).

L'acier inox est de préférence pré-nikelé avant la brasure à l'aide d'une couche de Ni d'épaisseur suffisante (par exemple 4 à 6 microns) pour empêcher la diffusion du chrome que contient l'inox et son oxydation lors de la brasure.

Le boîtier selon l'invention présente divers avantages. D'une part, le fond en matériau bon conducteur thermique constitue en lui-même un bon dissipateur thermique. L'utilisation d'une brasure dure pour le montage du cadre sur le fond, et plus particulièrement d'une brasure dure à température de fusion élevée permet d'assurer que la fixation du ou des substrats sur le fond du boîtier pourra être effectuée avec une brasure dure à température de fusion plus faible que la précédente, ce qui assurera le meilleur contact thermique possible, la brasure étant réalisée en phase vapeur, voire avec des brasures tendres présentant des températures de fusion élevées (par exemple 280 °C pour la brasure Sn-Pb-Ag, et jusqu'à 305 °C pour la brasure Pb-Ag), et qui, parmi les brasures tendres sont celles qui ont les meilleures propriétés thermiques.

D'autre part, l'adaptation des coefficients de dilatation entre le matériau constituant le cadre et celui constituant le fond permet d'éviter, lors du refroidissement de la brasure, qu'en dépit de la rigidité de la brasure dure à l'état solide, des contraintes résiduelles ne viennent provoquer un défaut de planéité du fond du boîtier préjudiciable à un bon contact thermique du substrat.

On notera que dans tous les cas, le brasage du substrat sur le fond pourra s'opérer avec la brasure dure dont la température de fusion est la plus faible à savoir l'Au-Sn qui peut être brasé à 280 °C.

**Revendications**

1. Boîtier à dissipation thermique élevée comportant un fond (1) en matériau bon conducteur de la chaleur sur lequel est rapporté par brasure un cadre métallique (2) supportant des connexions (5) par l'intermédiaire de traversées isolantes (6) en verre, caractérisé en ce que ladite brasure est une brasure dure, le matériau du cadre et celui du fond étant choisis en fonction de leur coefficient de dilatation thermique pour que le fond du boîtier en présente pas, pour l'application considérée, de défaut de planéité après le refroidissement consécutif au passage de la température de brasure à la température ambiante, les traversées isolantes étant en verre sodocalcique et ayant un coefficient de dilatation thermique inférieur ou égal à celui du matériau constituant le cadre métallique (2), les connexions (5) étant des broches en un alliage comportant au moins du fer et du nickel.

2. Boîtier selon la revendication 1, caractérisé en ce que le fond (1) est en oxyde de béryllium et le cadre (2) en un alliage fer-nickel comportant de 42 à 54% en poids de nickel.

3. Boîtier selon la revendication 2, caractérisé en ce que la proportion de nickel dans l'alliage est de 50%.

4. Boîtier selon l'une des revendications 2 ou 3, caractérisé en ce que la brasure comporte 42% d'argent, 33% de cuivre et 25% d'étain.

5. Boîtier selon l'une des revendications 2 ou 3, caractérisé en ce que la brasure comporte 72% d'argent et 28% de cuivre.

6. Boîtier selon la revendication 1, caractérisé en ce que le fond (1) est en cuivre et le cadre (2) en acier inoxydable.

7. Boîtier selon la revendication 6, caractérisé en ce que la brasure est en alliage or-nickel.

8. Boîtier selon l'une des revendications 6 ou 7, caractérisé en ce que le cadre (2) est pré-nickelé avant la brasure.

9. Boîtier selon une des revendications précédentes, caractérisé en ce qu'il comporte au moins un substrat brasé sur le fond à l'aide d'une brasure dure dont la température de brasage est inférieure à celle de la brasure utilisée pour le brasage du cadre métallique sur le fond.

10. Boîtier selon la revendication 9, caractérisé en ce que la brasure dure utilisée pour le brasage dudit substrat est de l'Au-Sn.

11. Boîtier selon une des revendications 1 à 8, caractérisé en ce qu'il comporte au moins un substrat brasé sur le fond à l'aide d'une brasure tendre à température de fusion élevée.

12. Boîtier selon la revendication 11, caractérisé en ce que la brasure est du Sn-Pb-Ag ou du Pb-Ag.

**Claims**

1. A case with a high level of heat dissipation comprising a bottom (1) of a material which is a good conductor of heat, to which there is attached by brazing a metal frame (2) supporting connections (5) by way of glass insulating passage means (6) characterised in that said brazing is a hard brazing, the material of the frame and that of the bottom being selected in dependence on their coefficient of thermal expansion so that, in regard to the use in question, the bottom of the case does not have any flatness defect after cooling resulting from going from the brazing temperature to the ambient temperature, the insulating passage means being of sodium-calcium glass and having a coefficient of thermal expansion which is lower than or equal to that of the material forming the metal frame (2), the connections (5) being pins of an alloy comprising at least iron and nickel.

2. A case according to claim 1 characterised in that the bottom (1) is of beryllium oxide and the frame (2) is of an iron-nickel alloy containing from 42 to 54% by weight of nickel.

3. A case according to claim 2 characterised in that the proportion of nickel in the alloy is 50%.

4. A case according to one of claims 2 and 3 characterised in that the brazing comprises 42% of silver, 33% of copper and 25% of tin.

5. A case according to one of claims 2 and 3 characterised in that the brazing comprises 72% of silver and 28% of copper.

6. A case according to claim 1 characterised in that the bottom (1) is of copper and the frame (2) is of stainless steel.

7. A case according to claim 6 characterised in that the brazing is of gold-nickel alloy.

8. A case according to one of claims 6 and 7 characterised in that the frame (2) is pre-nickel plated prior to the brazing operation.

9. A case according to one of the preceding claims characterised in that it comprises at least one substrate brazed to the bottom by means of a hard brazing whose brazing temperature is lower than that of the brazing used for brazing the metal frame to the bottom.

10. A case according to claim 9 characterised in that the hard brazing used for brazing said substrate is of Au-Sn.

11. A case according to one of claims 1 to 8 characterised in that it comprises at least one substrate brazed to the bottom by means of a soft brazing with a high melting temperature.

12. A case according to claim 11 characterised in that the brazing is of Sn-Pb-Ag or Pb-Ag.

**Patentansprüche**

1. Gehäuse mit hoher Wärmeableitung, das einen Boden (1) aus einem Wärme gut leitenden Werkstoff aufweist, auf dem durch Lötung ein Metallrahmen (2) angebracht ist, der Anschlüsse (5) mittels isolierender Durchführungen (6) aus Glas trägt, dadurch gekennzeichnet, dass die Lötung eine Hartlötung ist, der Werkstoff des Rahmens und der des Bodens als Funktion ihres Wärmedehnungskoeffizienten so gewählt sind, dass der Boden des Gehäuses dadurch für die betrachtete Verwendung keinen Ebenheitsfehler nach der Abkühlung aufgrund des Übergangs von der Löttemperatur auf die Umgebungstemperatur aufweist, die isolierenden Durchführungen aus Natrium-Kalziumglas sind und einen Wärmedehnungskoeffizienten unter oder gleich dem des den Metallrahmen (2) bildenden Werkstoffs haben und die Anschlüsse (5) Kontaktlamellen aus einer wenigstens Eisen und Nickel enthaltenden Legierung sind.

2. Gehäuse nach dem Anspruch 1, dadurch gekennzeichnet, dass der Boden (1) aus Berylliumoxid und der Rahmen (2) aus einer Eisen-Nickel-Legierung mit 42 bis 54 Gew.-% Nickel ist.

3. Gehäuse nach dem Anspruch 2, dadurch gekennzeichnet, dass der Nickelantiel in der Legierung 50% ist.

4. Gehäuse nach einem der Ansprüche 2 oder 3, dadurch gekennzeichnet, dass die Lötung 42% Silber, 33% Kupfer und 25% Zinn aufweist.

5. Gehäuse nach einem der Ansprüche 2 oder 3, dadurch gekennzeichnet, dass die Lötung 72% Silber und 28% Kupfer aufweist.

6. Gehäuse nach dem Anspruch 1, dadurch gekennzeichnet, dass der Boden (1) aus Kupfer und der Rahmen (2) aus nichtoxidierendem Stahl besteht.

7. Gehäuse nach dem Anspruch 6, dadurch gekennzeichnet, dass die Lötung aus Gold-Nickel-Legierung ist.

8. Gehäuse nach einem der Ansprüche 6 oder 7, dadurch gekennzeichnet, dass der Rahmen (2) vor der Lötung vorvernickelt wird.

9. Gehäuse nach einem der vorstehenden Ansprüche, dadurch gekennzeichnet, dass es wenigstens ein Substrat aufweist, das auf den Boden mit Hilfe eines Hartlots gelötet ist, dessen Löttemperatur unter der des zum Löten des Metallrahmens auf den Boden verwendeten Lots ist.

10. Gehäuse nach dem Anspruch 9, dadurch gekennzeichnet, dass das zum Löten des Substrats verwendete Hartlot Au-Sn ist.

11. Gehäuse nach einem der Ansprüche 1 bis 8, dadurch gekennzeichnet, dass es wenigstens ein Substrat aufweist, das auf den Boden mit Hilfe eines Weichlots mit erhöhtem Schmelzpunkt gelötet ist.

12. Gehäuse nach dem Anspruch 11, dadurch gekennzeichnet, dass das Lot Sn-Pb-Ag oder Pb-Ag ist.

FIG_1-a

FIG_1-b

FIG_1-c

FIG_1-d